# EUROPEAN PATENT SPECIFICATION

(11) **EP 3 374 194 B1**
(45) Date of publication and mention of the grant of the patent: **14.08.2019**
(21) Application number: 16777820.8
(22) Date of filing: 01.09.2016
(51) Int. Cl.: B41M 5/00, B41M 1/12, B41M 1/30, B41M 1/34, H01B 1/22, H05K 1/09, C09D 11/037, C09D 11/322, C09D 11/52, H05B 3/84, H05K 1/02, H05K 3/12

(54) **METHODS OF PRINTING WITH CONDUCTIVE PASTE**
VERFAHREN ZUM DRUCKEN MIT LEITFÄHIGER PASTE
PROCÉDÉS D'IMPRESSION AVEC PÂTE CONDUCTRICE

(30) Priority: 13.11.2015 US 201562254920 P
(43) Date of publication of application: 19.09.2018
(73) Proprietor: Exatec, LLC., Wixom, MI 48393 (US)
(72) Inventor: NELSON, Mark Kevin, Mt. Vernon, Indiana 47620-9367 (US); SHULER, Stephen, Wixom, Michigan 48393 (US); SCHOUWENAAR, Richard, 4612 PX Bergon op Zoom (NL)
(74) Representative: Delorme, Nicolas
(86) International application number: PCT/US2016/049865
(87) International publication number: WO 2017/082995

(56) References cited:
- EP-A1- 1 835 512
- EP-A1- 2 123 723
- US-A1- 2009 167 817

## Description

### CROSS-REFERENCE TO RELATED APPLICATION

This application claims the benefit of U.S. Provisional Patent Application Serial No. 62/254,920 filed November 13, 2015.

### TECHNICAL FIELD

Disclosed herein are printing methods for making conductive lines on plastic substrates for use in automobiles.

### BACKGROUND

In a window defroster, a busbar is used to distribute electrical current to each grid line of the defroster in an attempt to evenly heat the entire defroster grid. A defroster can be formed using robotic printing mechanisms by printing directly onto the inner or outer surface of a panel, or on the surface of a protective layer, using a conductive ink or paste. Forming a defroster using conventional printing methods often results in grid lines with uneven thickness, entrained bubbles, or even breaks in the lines. All of these defects disadvantageously result in a reduction in efficiency of the defroster.

It is known from document EP1835512 a conductive ink comprising a solvent, a metal powder, and an adhesion improver, wherein the adhesion improver is selected from the group consisting of a silane coupling agent, a titanium coupling agent, a zirconium coupling agent, and an aluminum coupling agent.

Document EP2123723 discloses a method of forming an ink, including photochemically producing stabilized metallic nanoparticles and formulating the nanoparticles into an ink.

Document US2009/167817 discloses an apparatus for printing an image onto a curved surface of a three dimensional article.

Accordingly, an improved method for printing a window defroster is desired.

### BRIEF SUMMARY

Disclosed herein are printing methods for making conductive lines on plastic substrates for use in automobiles.

In an embodiment, a printing method for forming a conductive line on a plastic substrate for use in an automobile, comprises: fixing the plastic substrate in a fixture of an automatic printing machine; dispensing a conductive mixture to an inkjet print head of the automatic printing machine, the inkjet print head being coupled to the fixture and configured for printing on the plastic substrate; and controlling the inkjet print head of the automatic printing machine with a computer controller under automatic controls and printing the conductive mixture onto the plastic substrate with the inkjet print head while the plastic substrate is fixed in the fixture to form the conductive line; wherein the conductive mixture comprises a conductive paste; a solvent; and an adhesion agent; wherein the conductive line is a busbar, a grid line, or an antenna line in the automobile.

In another embodiment, a printing method for forming a conductive line on a plastic substrate for use in an automobile, comprises: fixing the plastic substrate in a fixture of an automatic printing machine comprising the fixture, a screen located above the fixture, and a squeegee; dispensing a conductive mixture onto a surface of the screen; printing the conductive mixture by displacing the squeegee over the surface of the screen with an applied pressure in a downward direction on the screen such that the conductive mixture floods through an open mesh space in the screen onto the surface of the plastic substrate to form the conductive line; and wherein the conductive mixture comprises a conductive paste; a solvent; and an adhesion agent; wherein the conductive line is a busbar, a grid line, or an antenna line in the automobile.

The above described and other features are exemplified by the following figures and detailed description.

### BRIEF DESCRIPTION OF THE DRAWINGS

Refer now to the figures, which are exemplary embodiments, and wherein the like elements are numbered alike.
FIG. 1 is an illustration of a prior art method of dispensing a conductive paste;
FIG. 2 is a photograph of the printed line of Example 1;
FIG. 3 is a photograph taken on a microscope of the printed line of Example 1;
FIG. 4 is an illustration of an embodiment of the inkjet printing of the conductive mixture;
FIG. 5 is a photograph of the printed line of Example 2;
FIG.6 is a photograph taken on a microscope of the printed line of Example 2;
FIG. 7 is an illustration of an embodiment of a rear window defroster;
FIG. 8 is an illustration of an embodiment of a 2K molded rear window defroster;
FIG. 9 is an illustration of an embodiment of a glazing panel;
FIG. 10 is an illustration of the method of printing; and
FIGs. 11 and 12 are illustrations of an embodiment of a three-dimensional screen printing device.

### DETAILED DESCRIPTION

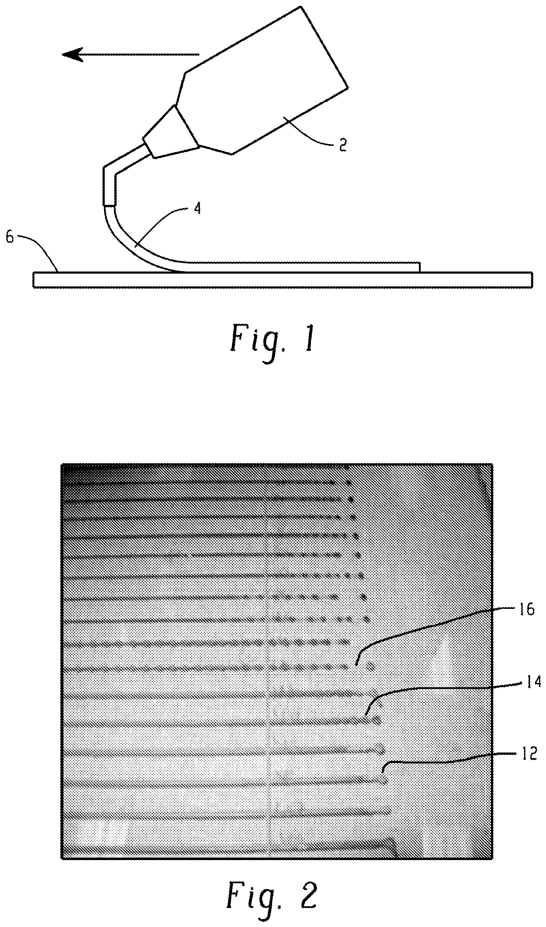

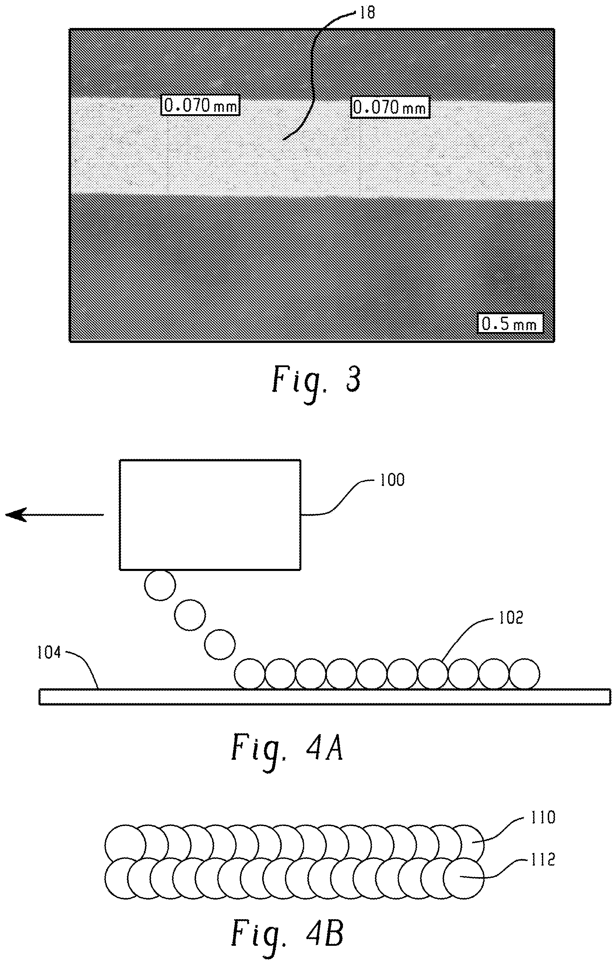

Formation of a heater grid is a balance of several factors, including the requirement for uniformity versus the practical consideration of production speed. Uniformity is an important characteristic since it affects both aesthetics and function; e.g., affecting resistance and hence heating results. Traditional methods of printing heater grids include flowing a continuous stream of a conductive material onto a substrate, for example, as is illustrated in FIG. 1. FIG. 1 illustrates print head 2 moving in the direction of the arrow. A continuous line of conductive paste 4 flows out of print head 2 leaving a conductive line on substrate 6. FIG. 2 and FIG. 3 show that this printing method can result in a myriad of print defects, including pooling 12 that can occur during start-up, bead formation 14, line break 16, or discontinuities 18 arising from entrained bubbles in the conductive paste.

The inventors hereof surprisingly discovered a conductive mixture that can be printed, for example, by inkjet printing and by screen printing that is able to produce an improved conductive line, such as a grid line and a busbar, onto a substrate. The printing can print a uniform conductive line on a substrate, i.e., having a uniform width along its entire length. Uniform as used herein is a deviation from the target width of the particular zone of less than or equal to 20%. In other words, for a target width of 1.0 millimeters (mm), the deviation would be less than or equal to ±0.2 mm, for example, ±0.1 mm. This level of precision now opens new opportunities for defroster production. It also provides entry into other similar applications, such as conductive signal pathways to replace wiring harnesses.

The conductive mixture (also referred to herein as the mixture) comprises a conductive paste, a solvent, and an adhesion agent, for example, comprising bis(triethoxysilyl)ethane. The conductive paste can comprise a plurality of metallic particles dispersed in a polymeric matrix (such as a polyacrylate). The plurality of metallic particles can comprise silver, copper, gold, nickel, palladium, platinum, or a combination comprising at least one of the foregoing. The plurality of metallic particles can comprise silver particles. The particles can have an average particle size as measured on a long axis of the particle of 20 to 2,000 nanometers (nm), specifically, 20 to 1,000 nm. The particles can have an average particle size as measured on a long axis of the particle of 20 to 200 nm, for example, 20 to 50 nm. The particles can be coated, for example, with a coating comprising polyvinylpyrrolidone, polyvinyl alcohol, methyl cellulose, polyethylene glycol, polyacrylic acid, polymaleic acid, polymethylmethacrylate, or a combination comprising at least one of the foregoing. The coating can be present in an amount of 5 to 14 weight percent (wt%) based on the total weight of the coated particles.

The conductive paste can comprise 30 to 85 wt%, or 8 to 15 wt% of the plurality of metallic particles based on the total weight of the composition.

The solvent can comprise a C₃₋₁₀ alkyl ketone, a C₃₋₁₀ cycloalkyl ketone, an alcohol, an ether, or a combination comprising at least one of the foregoing. The solvent can comprise ethanol, methanol, glycol ether, acetone, butanone, 3,3-dimethyl-2-butanone, 2-pentanone, 3-pentanone, 3,3-dimethyl-2-pentanone, 4,4-dimethyl-2-pentanone, 3,4-dimethyl-2-pentanone, 2,4-dimethyl-3-pentanone, 4-methyl-2-pentanone, 3-methyl-2-pentanone, cyclopentanone, 2-hexanone, 3-hexanone, 5-methyl-2-hexanone, 4-methyl-2-hexanone, 3-methyl-2-hexanone, 2-methyl-3-hexanone, 4-methyl-3-hexanone, 5-methyl-3-hexanone, 2-methyl-3-pentanone, cyclohexanone, 2-methylcyclohexanone, 3-methylcyclohexanone, 4-methylcyclohexanone, 2-heptanone, 3-heptanone, 4-heptanone, cycloheptanone, 2-octanone, 3-octanone, 4-octanone, cycloctanone, a C₉ ketone, a C₁₀ ketone, or a combination comprising at least one of the foregoing.

The solvent can be present in an amount of 0.1 to 5 grams, specifically, 0.5 to 2 grams of solvent per 30 grams of the conductive paste.

The adhesion agent can comprise a silane, for example, a silane comprising a hydroxyl, a methoxy, an ethoxy group, or a combination comprising at least one of the foregoing. The adhesion agent can comprise gamma-isocyanatopropyltriethoxysilane, gamma-isocyanatopropyltrimethoxysilane, n-ethyl-3-trimethoxysilyl-2-methyl propanamine, n-beta-(aminoethyl)-gamma-aminopropyltrimethoxysilane, 3-aminopropyltriethoxysilane, triethoxysilylpropylenecarbamate, glycidoxypropyltrimethoxysilane, methyltrimethoxysilane, neopentyl(diallyl)oxytri(dodecyl)benzene-sulfonyl titanate, vinylbenzylethylene diaminepropyl trimethoxysilane monohydrochloride, vinyltrimethoxysilane, octadecylaminodimethyl trimethoxysilyl propyl ammonium chloride, cyanodecyltrimethoxysilane, mercaptopropyltrimethoxysilane, chloropropyltrimethoxysilane, bis(triethoxysilyl)ethane, or a combination comprising at least one of the foregoing. The adhesion agent can comprise gamma-isocyanatopropyltriethoxysilane, gamma-isocyanatopropyltrimethoxysilane, n-ethyl-3-trimethoxysilyl-2-methyl propanamine, n-beta-(aminoethyl)-gamma-aminopropyltrimethoxysilane, 3-aminopropyltriethoxysilane, vinylbenzylethylene diaminepropyl trimethoxysilane monohydrochloride, cyanodecyltrimethoxysilane, mercaptopropyltrimethoxysilane, chloropropyltrimethoxysilane, bis(triethoxysilyl)ethane, or a combination comprising at least one of the foregoing.

The adhesion agent can be present in an amount of 0.1 to 2 grams, specifically, 0.1 to 1 grams per 30 grams of the conductive paste. The adhesion agent can comprise bis(triethoxysilyl)ethane and the bis(triethoxysilyl)ethane can be present in an amount of 0.1 to 2 grams, specifically, 0.1 to 1 grams per 30 grams of the conductive paste.

The conductive mixture can comprise an additive. The additive can comprise a colorant (such as a dye and a pigment), a binder (such as a polyacrylate, polyvinyl butyral, and ethylcellulose), an ionizable material (such as ammonium acetate and diethylamine hydrochloride), a resistance modifying agent (such as carbon (such as carbon nanotubes, graphite, and graphene)), or a combination comprising at least one of the foregoing. The resistance modifying agent can have a particle size of less than or equal to 500 nm, specifically, 50 to 500 nm, more specifically, 100 to 400 nm.

The conductive mixture can be free of water. For example, the conductive mixture can comprise less than or equal to 2 wt% water, specifically, less than or equal to 0.5 wt% water, or 0 wt% water based on the total weight of the mixture.

The conductive mixture can have a viscosity that is less than the viscosity of the conductive paste. The mixture can have a viscosity of less than or equal to 45,000 millipascal seconds (mPa-s), specifically, 10,000 to 22,000 mPa-s, more specifically, 13,000 to 15,000 mPa-s. Viscosity as used herein can be measured using a VISCOTESTER VT-04F, stainless steel No. 2 rotor using a 300 mL JIS R 3503:1194 ϕ78×103 (H) beaker. The mixture, for example, when used for inkjet printing, can have a viscosity of less than or equal to 36,000 mPa-s, specifically, 10,000 to 22,000 mPa-s, more specifically, 13,000 to 15,000 mPa-s. The mixture, for example, when used for screen printing, can have a viscosity of less than or equal to 45,000 mPa-s, specifically, 20,000 to 45,000 mPa-s, more specifically, 30,000 to 40,000 mPa-s.

The mixture can be formed by mixing the conductive paste, the solvent, and the adhesion agent to form a homogeneous mixture. Prior to mixing, the conductive paste can be stored at a cold storage temperature of 0 to 10 degrees Celsius (°C), specifically, 2 to 6°C. The conductive paste can be stored at the cold storage temperature for less than or equal to 6 months. If the conductive paste is stored at the cold storage temperature, then the cold conductive paste can be warmed from the cold storage temperature to an increased temperature of 11 to 30°C prior to forming the mixture.

After forming the mixture, for example, by adding the solvent and the adhesion agent to the conductive paste and mixing, the mixture can be degassed. After the degassing, at least a portion of the mixture can be transferred to a dispensing container, for example, a syringe, optionally followed by degassing the mixture in the dispensing container within 2 hours of the transferring. The degassing can comprise centrifugally rotating the mixture at a centrifugal force (G) of greater than or equal to 350 G, specifically, greater than or equal to 400 G. The degassing can be performed in a THINKY mixer commercially available from Thinky USA, INC., of Laguna Hills, CA.

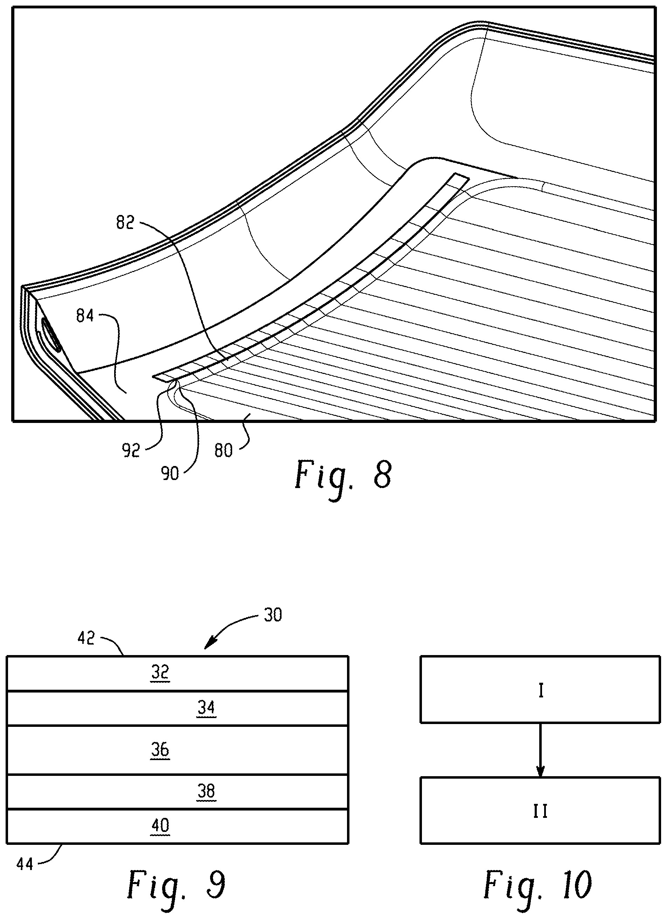

FIG. 10 illustrates that the method of printing can comprise forming the mixture in step I and printing the mixture in step II.

The printing method can print a conductive line having a width of 0.3 to 25 mm, for example, 0.3 to 5 mm, specifically, 0.4 to 0.6 mm, or 1 to 3 mm. The conductive line can have an average width of a first two millimeters of the line that is within 10% of an average width of a two millimeter long location downstream of the first two millimeters. The width of the conductive line can be adjusted, for example, when inkjet printing by one or both of adjusting the droplet size and increasing the number of passes. For example, the width of the conductive line can be increased by printing a second series of droplets next to and in contact with a first series of printed droplets as is illustrated in FIG. 4, where the width of the conductive line is effectively doubled in the illustration. The width of the conductive line can be adjusted, for example, when screen printing, by increasing a width of open mesh that the conductive mixture can penetrate.

The conductive line can have a height of less than or equal to 0.5 mm, specifically, less than or equal to 0.1 mm, more specifically, 0.025 mm to 0.05 mm from the surface on which the conductive line is printed. The height of the conductive line can be adjusted, for example, when inkjet printing by one or both of adjusting the droplet size and increasing the number of passes. For example, the height of the conductive line can be increased by printing a second series of droplets on top of a first series of printed droplets.

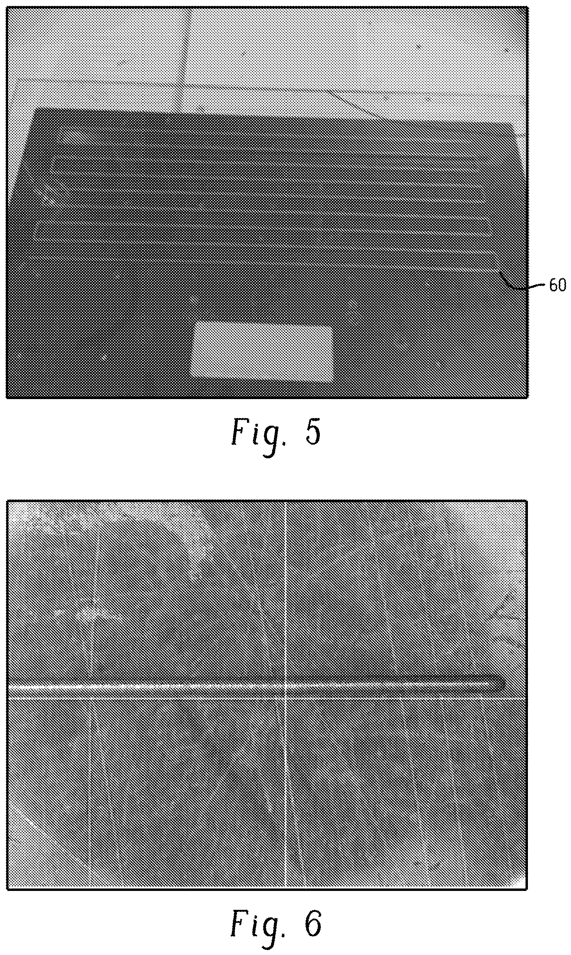

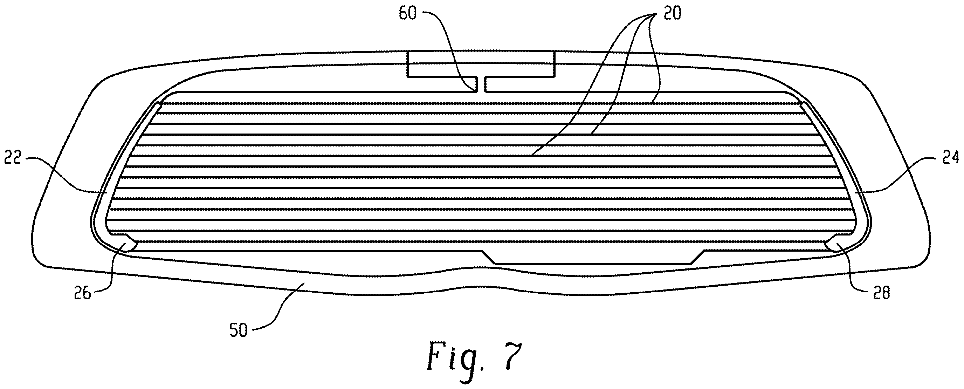

The printing method (such as the inkjet printing and the screen printing) can print a conductive line with a 90° angle, for example, as is shown in FIG. 5 and as is illustrated in FIG. 7 as 90° angle 60.

The substrate can be a 3D substrate with a non-flat printing surface. For example, the printing surface can be convex, concave, or a combination thereof based on where the desired image is to be printed. The substrate can be received on a receiving surface prior to printing that can correspond to a surface of the substrate. The substrate can be secured to the fixture, for example, by vacuum, for example, with a series of vacuum cups. The fixture can have fiducial marks or datum locators that can create a part-coordinate system in space to facilitate alignment of the printing mechanism and the substrate.

The printing can comprise inkjet printing the mixture onto a substrate to form a series of droplets, forming the conductive line. For example, FIG. 4 illustrates print head 100 dispensing series of droplets 102 onto substrate 104. The conductive line can comprise a single pass of a series of droplets or multiple passes, for example, first pass 110 and second pass 112.

The inkjet printing can occur by dispensing droplets of the conductive mixture via an inkjet print head onto the surface of the substrate. It was surprisingly found that a barrel and piston inkjet print head was able to print more consistent lines having a more consistent line width than a screw driven inkjet print head. The inkjet print head can be a PICO VALVE commercially available from Nordson EFD of Nordson Corporation, East Providence, RI. The inkjet print head can comprise a barrel and piston pressurized dispenser operating at 300 to 700 kilopascal (kPa), specifically, 400 to 600 kPa. The inkjet print head can be driven by at least two piezoelectric actuators that can work to raise and lower a seal, such as, a sealing ball to allow the conductive mixture to be released. The inkjet printing can occur at a frequency of 100 to 1,500 hertz (Hz), specifically, 100 to 1,000 Hz, more specifically, 300 to 500 Hz. The inkjet printing can occur at a speed of 160 to 300 millimeters per second (mm/s), specifically, 230 to 280 mm/s. The inkjet printing can occur at a speed of 160 to 600 mm/s, specifically, 300 to 400 mm/s. The inkjet printing can occur at a speed of 50 to 200 mm/s, specifically, 75 to 150 mm/s. The inkjet print head can optionally comprise a dispensing needle.

The inkjet printing system can comprise an inkjet print head, an articulatable robot arm, a dispenser, a supply source, a controller, a flow regulator, a sensor, a valve, a connector, a gauge, a heater, and so forth, as well as combinations comprising at least one of the foregoing. The inkjet print head can be located on the robot arm and can be connected to the dispenser for dispensing the mixture from the supply source. The inkjet print head can comprise two or more print heads and the inkjet printing can comprise controlling the dispensing of the series of droplets from each of the two or more print heads independently based upon a set of values stored in a memory of the controller.

Relative motion can be created between the inkjet print head and the substrate. For example, the robot arm can be articulatable and capable of moving the inkjet print head to a location on the surface of the substrate. Conversely, the inkjet print head can remain stationary while the substrate can be articulated to move relative to the inkjet print head. In another embodiment, the inkjet print head and the substrate can be articulated to create relative motion between one another. The inkjet print head can be attached to an articulatable robot arm that can have 3 to 6 degrees, specifically, 6 degrees of freedom of movement.

A controller can be in operable communication with the robot arm and the dispenser. A flow regulator can be in operable communication with the dispenser. The flow regulator can be any device capable of controlling the flow rate of conductive mixture to the inkjet print head. For example, the flow regulator can be a dispensing controller, e.g., wherein the air pressure is set constant, and the controller is used to turn on/off air via an internal solenoid valve. Additionally, or alternatively, the robot arm can sense the current print head location on a path and issue a change to an analog voltage output signal. The analog output signal can control an "I/P controller" or air regulator controlled by an analog signal in order to change the pressure applied to the dispenser reservoir on command. For on/off control of the applied air pressure, and therefore paste stream output, the output air pressure can be controlled through a solenoid valve.

The inkjet printing can occur in accordance with a preprogrammed printing path. Such that the print head follows the preprogrammed printing path that is output, for example, from a controller. The surface of the article can be scanned prior to printing and the preprogrammed printing path can be modified to form a modified printing path, for example, to accommodate for surface defects on the surface of the substrate.

To increase the uniformity of the inkjet printed lines, a sensor can directly or indirectly measure one or both of the distance(s) of the inkjet print head from the surface of the substrate and the relative angle of the inkjet print head with the surface of the substrate. For example, the inkjet printing can comprise: determining a height between a sensor or the inkjet print head and a surface of the substrate, adjusting the height if the height does not equal a desired height by creating relative motion between the inkjet print head and the substrate, creating relative motion between the inkjet print head and the substrate in the y-direction, and dispensing the conductive mixture from the inkjet print head onto the surface of the substrate to form the line. The sensor can be in operable communication with a controller and positioned to sense the surface of the substrate at a distance of less than or equal to 6 mm, specifically, 2 to 5 mm, and more specifically, 3.5 to 4.5 mm from a point where an inkjet print head dispenses the conductive mixture onto the panel. Likewise, the inkjet printing can comprise determining an angle between the print head sensor and the surface of the substrate, adjusting the angle if the angle does not equal a desired angle by creating relative motion between the print head and the substrate, and dispensing the conductive mixture from the print head onto the surface of the substrate to form the line. The inkjet print head can be maintained at an angle normal to the surface of the substrate.

The sensor can be any sensor capable of measuring one or both of a height and an angle from the surface sensed by the sensor. The sensor can comprise a laser. Since the panel is generally transparent plastic, the sensor can be capable of measuring relative to a semi-reflective and/or transparent surface. The sensor can be a laser triangulation sensor, an ultrasonic sensor, a photonic sensor (i.e., measures the intensity of the reflected light), an air pressure sensor, a magnetic sensor, a contact sensor, or a combination comprising at least one of the foregoing. The sensor can be a laser triangulation sensor.

The inkjet printing can comprise reducing the speed of the inkjet print head at a location where a surface height is increased or decreased, for example, due to a 2K molded surface feature. For example, FIG. 8 illustrates a 2K molded feature that results in an increase in height relative to the print head. Here, the print head can continuously print the conductive line on first surface 80, angled surface 82, and raised surface 84, and one or more of a dispensing rate, a printing speed, and a height of the print head can be adjusted in order to maintain a uniform width of the conductive line. In conventional printing, such as continuous printing, it is very difficult to maintain a uniform line during printing over raised surface features such as the one illustrated here, and pools of the conductive paste are often formed at locations 90 and 92.

The inkjet printing can comprise monitoring the printed line for a line defect. If the line defect occurs, then the method can further comprise retaining a defect location, for example, by storing a set of values in a memory corresponding to the defect location. If the defect is a line break (also referred to as a void) in the line, then the method can comprise automatically printing in the line break after the inkjet printing.

The printing can comprise screen printing. In general, screen printing comprises bringing a screen in close proximity to a substrate, applying a conductive mixture, and displacing a squeegee over the surface of the screen with an applied force on the screen such that the conductive mixture floods through an open mesh space in the screen onto the surface of the substrate. The screen can comprise a polyester fabric (for example, comprising monofilament polyester fibers), a polyamide fabric (for example, comprising monofilament polyamide fibers), or a combination comprising at least one of the foregoing. The screen can have a mesh size that can be 3 to 5 times larger than the particle size of the particles in the conductive mixture. The screen comprises an inverse image of the desired image printed thereon such that the conductive mixture can penetrate through the open mesh space of the screen to print the desired image onto the substrate. The screen printing can occur at a temperature of 20 to 25°C.

The squeegee can comprise a polyurethane, a rubber, or a combination comprising at least one of the foregoing. The squeegee can print at a speed of 10 to 50 mm/s, specifically, 20 to 40 mm/s, more specifically, 25 to 35 mm/s. The squeegee can exert a pressure of 100 to 800 kPa, specifically, 300 to 600 kPa. The squeegee can be wedged or rectangular. During printing, the squeegee can be at an angle of 45 to 90°, specifically, 55 to 90° relative to the surface of the substrate. The length of the squeegee assembly 20 can be greater than the width of the image 44 and can be as large as or larger than the distance across the substrate. The squeegee can have a working edge and a fixed edge, wherein the working edge is the edge that contacts the screen.

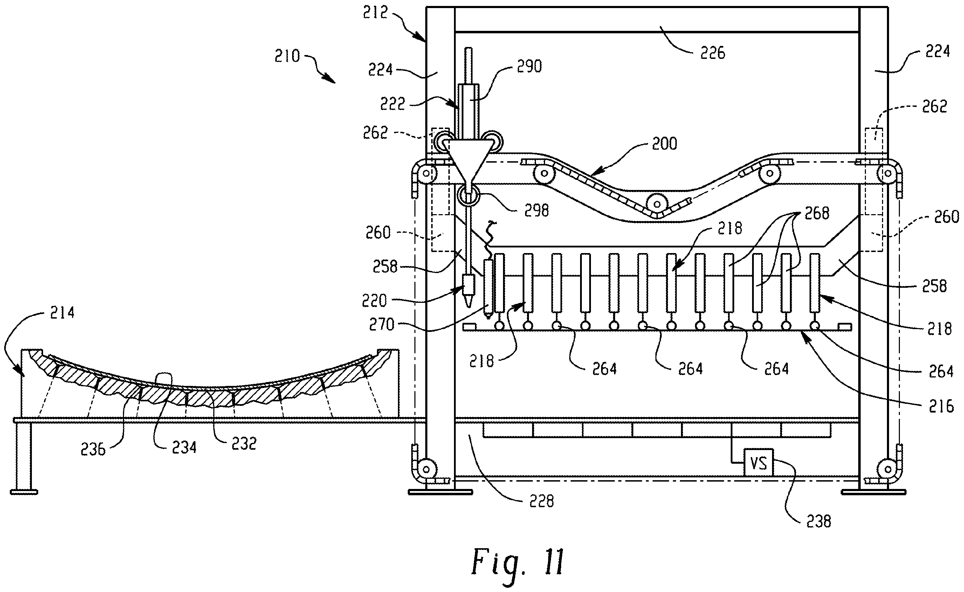

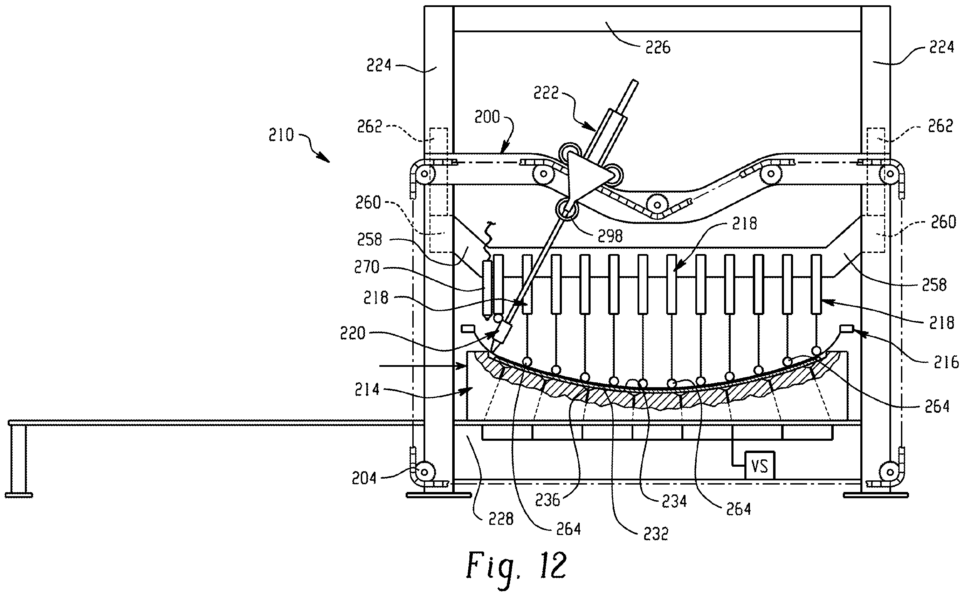

The screen printing can print on a three-dimensional (3D) substrate comprising a curvature. An example of a 3D screen printing device 210 is illustrated in FIGs. 11 and 12, where FIG. 11 is an illustration of the substrate in the device just after loading and FIG. 12 is an illustration of the substrate in a printing position and where printing is just initiated. The 3D screen printing device 210 can comprise frame 212, substrate fixture 214, screen assembly 216, various means for tensioning and shaping the screen assembly, squeegee assembly 220, and a mechanism for conforming and drawing squeegee assembly 220 across screen assembly 216. Frame 212 can comprise a plurality of upright support posts 224, between which extend cross-braces 226. Frame 212 can comprise bed 228, upon which substrate fixture 214 can be positioned for printing.

The printing surface of substrate 232 can be convex, concave, or a combination thereof based on where the desired image is to be printed. Substrate 232 can be received on receiving surface 234 of fixture 214. Receiving surface 234 can correspond to a surface of substrate 232. Substrate 232 can be secured to fixture 214, for example, by vacuum, for example, with a series of vacuum cups 236. Once substrate 232 is secured to fixture 214, fixture 214 can be moved into printing position as illustrated in FIG. 12 and screen assembly 216 can be moved towards fixture 214. Screen assembly 216 can comprise a screen and a screen frame. The screen frame can be flexible so as to enable the screen surface to conform to the 3D surface of substrate 232. Screen shapers 218 can optionally be present and can be adjusted to shape screen frame 242 such that the screen is within a specified distance, for example, within 1 centimeter (cm), specifically, within 0.5 cm of a printing surface of the substrate.

Screen shapers 218 can be located on one or more base rails 258. Base rails 258 can be supported on one or more support members 260 that can be coupled to actuators 262 that can be, for example, pneumatically driven, hydraulically driven, electrically driven, or magnetically driven actuators. Contacts 264 can be located at the screen end of screen shapers 218 that can reduce the risk of screen shapers 218 puncturing the screen. Screen shapers 218 can be retractable so as to allow the squeegee to pass by without contact.

A conductive ink, such as the conductive mixture can be dispensed onto the screen, for example, by dispensing mechanism 270 prior to printing. The dispensing mechanism 270 can apply the conductive ink in a line, wherein the line can be oriented along a length of the squeegee. A flood bar can be used to spread the ink across a surface of the screen 240 prior to traversing the squeegee along the screen. The conductive ink can be applied prior to or after screen deformation. With the screen deformed as seen in FIG. 2, squeegee assembly 20 can then be drawn across screen 40 by the mechanism for drawing or the squeegee advancing mechanism 222.

To draw squeegee assembly 220 across the surface of screen 40, squeegee advancing mechanism 222 can move to a starting position seen in FIG. 2 where squeegee 272 initially engages screen 240. Squeegee assembly 240 can be constructed so as to be able to continuously conform to the shape of the surface of substrate 232 as it is drawn there across. Squeegee advancing mechanism 222 can comprise rollers 298 that roll along guide rail 200. Guide rail 200 can be shaped such that squeegee assembly 220 will generally follow the shape of the substrate as the squeegee is advanced. It will be appreciated, however, that guide rail 200 could alternatively be provided as a straight member wherein squeegee assembly 220 is adjusted in position relative to substrate 232 by actuators 292, with or without additional actuators, and an electronic controller specifically programmed to cause squeegee 272 to follow the shape of substrate 232.

The angle of the squeegee can be adjusted during the displacing the squeegee across the surface of the substrate. For example, the angle relative to a tangent line at a given location on a substrate can be maintained, for example, to be within 15% of a set point.

The portions of the printing system, such as one or both of the inkjet printing system and the screen printing system that come into physical contact with the conductive mixture, can optionally be temperature controlled (e.g., heated and/or cooled) so as to maintain the mixture within a predetermined temperature range. For example, these portions can be temperature controlled (heated and/or cooled) to minimize the effect of temperature induced changes in the rheology of the conductive mixture. For example, the temperature of the conductive mixture can be maintained above room temperature so as to encompass any fluctuations in room temperature, yet below a temperature that would negatively affect the conductive mixture (i.e., degrade the conductive mixture). For example, the substrate, the print head, a flow regulator, and the source of conductive mixture can be at room temperature, for example, at 23°C, or can be heated such as to a temperature of 25 to 30°C.

The conductive trace can be sintered after printing.

The substrate can comprise a plastic panel. The plastic panel can comprise a thermoplastic polymer. The thermoplastic polymer can comprise a polycarbonate, a polyacrylate (such as polymethylmethyacrylate), a polyarylate, a polyester, a polysulfone, or a combination comprising at least one of the foregoing. The plastic panel can comprise a polycarbonate.

The substrate can be a transparent substrate. For example, the transparent substrate can have a light transparency of greater than or equal to 90%, specifically, greater than or equal to 95% as determined using 3.2 mm thick samples using ASTM D1003-00, Procedure B using CIE standard illuminant C, with unidirectional viewing.

The substrate can include areas of opacity. For example, an opaque ink or the like can be applied (e.g., printed) on the substrate in the form of a black-out border or a border can be molded using an opaque resin. The area of opacity can be an opaque border located in an area proximal to an edge of the substrate.

The plastic panel can comprise one or more protective layers. As the term is used herein, a substrate with protective layer(s) is a transparent glazing panel. The protective layer can comprise a plastic film, an organic coating, an inorganic coating, or a combination comprising at least one of the foregoing. The plastic film can be of the same or different composition as the substrate. The protective layer can be located on top of both the plastic panel and the printed image. The protective layer can be located in between the plastic panel and the printed image. A first protective layer (for example, a UV absorbent layer) can be located in between the plastic panel and the printed image and a second protective layer (for example, an abrasion resistant layer) can be located on top of both the plastic panel and the printed image.

The protective layer can comprise an abrasion resistant layer. The abrasion resistant layer can comprise one or both of an organic coating and an inorganic coating. The organic coating can comprise a urethane, an epoxide, an acrylate, or a combination comprising at least one of the foregoing. The inorganic coating can comprise silicone, aluminum oxide, barium fluoride, boron nitride, hafnium oxide, lanthanum fluoride, magnesium fluoride, magnesium oxide, scandium oxide, silicon monoxide, silicon dioxide, silicon nitride, silicon oxy- nitride, silicon oxy-carbide, silicon carbide, tantalum oxide, titanium oxide, tin oxide, indium tin oxide, yttrium oxide, zinc oxide, zinc selenide, zinc sulfide, zirconium oxide, zirconium titanate, glass, or a combination comprising at least one of the foregoing.

The abrasion resistant layer can be applied by deposition from reactive species, such as those employed in vacuum-assisted deposition processes, and atmospheric coating processes, such as those used to apply sol-gel coatings to substrates. Examples of vacuum-assisted deposition processes include plasma enhanced chemical vapor deposition, ion assisted plasma deposition, magnetron sputtering, electron beam evaporation, and ion beam sputtering. The abrasion resistant layer can be applied by a vacuum deposition technique plasma-enhanced chemical vapor deposition (PECVD), expanding thermal plasma PECVD, plasma polymerization, photochemical vapor deposition, ion beam deposition, ion plating deposition, cathodic arc deposition, sputtering, evaporation, hollow-cathode activated deposition, magnetron activated deposition, activated reactive evaporation, thermal chemical vapor deposition, or a sol-gel coating process. Examples of atmospheric coating processes include curtain coating, spray coating, spin coating, dip coating, and flow coating, as well as combinations comprising at least one of the foregoing. The abrasion resistant layer can be applied via any technique or combination comprising at least one of the foregoing.

A specific type of PECVD process used to deposit the abrasion resistant layers comprising an expanding thermal plasma reactor is preferred. In an expanding thermal plasma PECVD process, a plasma is generated via applying a direct-current (DC) voltage to a cathode that arcs to a corresponding anode plate in an inert gas environment. The pressure near the cathode is typically higher than 20 kPa, e.g., close to atmospheric pressure, while the pressure near the anode resembles the process pressure established in the plasma treatment chamber of 2 to 14 pascal (Pa). The near atmospheric thermal plasma then supersonically expands into the plasma treatment chamber.

The reactive reagent for the expanding thermal plasma PECVD process can comprise, for example, octamethylcyclotetrasiloxane (D4), tetramethyldisiloxane (TMDSO), hexamethyldisiloxane (HMDSO), vinyl-D4, or another volatile organosilicon compound. The organosilicon compounds are oxidized, decomposed, and polymerized in the arc plasma deposition equipment, typically in the presence of oxygen and an inert carrier gas, such as argon, to form an abrasion resistant layer.

The UV absorbent layer can comprise a silicone, a polyurethane, an acrylic, a polyester, an epoxy, or a combination comprise at least one of the foregoing. The UV absorbent layer can comprise ultraviolet (UV) absorbing molecules, such as 4,6-dibenzoyl resorcinol (DBR), hydroxyphenyltriazine, hydroxybenzophenones, hydroxylphenyl benzotriazoles, hydroxyphenyltriazines, polyaroylresorcinols, 2-(3-triethoxysilylpropyl)-4,6-dibenzoylresorcinol) (SDBR), a cyanoacrylate, or a combination comprising at least one of the foregoing. The UV absorbing molecules can help to protect the underlying plastic panel and conductive mixture from degradation caused by exposure to the outdoor environment.

The UV absorbent layer can comprise one homogenous layer or can comprise multiple sub-layers, such as a primer layer and a topcoat layer. The primer layer can aid in adhering the topcoat to the plastic panel. The primer layer, for example, can comprise an acrylic, a polyester, an epoxy, or a combination comprising at least one of the foregoing. The topcoat layer can comprise polymethylmethacrylate, polyvinylidene fluoride, silicone (such as a silicone hardcoat), polyvinylfluoride, polypropylene, polyethylene, polyurethane, polyacrylate (such as polymethacrylate), or a combination comprising at least one of the foregoing. A specific example of a UV absorbent layer comprising multiple sub-layers is the combination of an acrylic primer (SHP401 or SHP470, available from Momentive Performance Materials, Waterford, NY; or SHP-9X, available from Exatec LLC, Wixom, MI) with a silicone hard-coat (AS4000 or AS4700, available from Momentive Performance Materials; or SHX, available from Exatec LLC).

A variety of additives can be added to the UV absorbent layer, e.g., to either or both the primer and the topcoat, such as colorants (tints), rheological control agents, mold release agents, antioxidants, and IR absorbing or reflecting pigments, among others. The type of additive and the amount of each additive is determined by the performance required by the plastic glazing panel to meet the specification and requirements for use as a window.

The plastic panel and/or the protective layer(s) can comprise additive(s) to modify optical, chemical, and/or physical properties. Some possible additives include for example, mold release agents, ultraviolet light absorbers, stabilizers (such as light stabilizers, thermal stabilizers, and so forth), lubricants, plasticizers, rheology control additives, dyes, pigments, colorants, dispersants, anti-static agents, blowing agents, flame retardants, impact modifiers, among others, such as transparent fillers (e.g., silica, aluminum oxide, etc.) to enhance abrasion resistance. The above additives can be used alone or in combination with one or more additives.

The conductive line can be printed directly onto one or both of the inner surface and the outer surface of the substrate, where the inner surface refers to the surface that is inside when in use, for example, in a vehicle or a building, and the outer surface refers to the surface that is outside when in use. Alternatively, the conductive line can be printed on the surface of one or more of a protective layer and the panel. For example, referring to FIG. 9, glazing panel 30 can comprise abrasion layer 32, UV absorbent layer 34, plastic panel 36, optional UV weathering layer 38, and optional abrasion layer 40. The conductive line can be located on the surface of abrasion layer 32 that is opposite of UV absorbent layer 34, in between abrasion layer 32 and UV absorbent layer 34, in between UV absorbent layer 34 and plastic panel 36, or on the surface of plastic panel 36 opposite UV absorbent layer 34. It is noted that each of the possible positions for the conductive line can offer different benefits in relation to overall performance and cost. For example, positioning the conductive line closer to external surface 42 of the substrate can minimize the time necessary to defrost the substrate, whereas positioning the conductive line closer to internal surface 44 of a substrate can offer benefits in terms of ease of application and lower manufacturing costs.

The conductive line can be part of a heater grid, for example, it can be a busbar and/or a grid line. The heater grid can comprise an inkjet printed grid line and a screen printed busbar. For example, FIG.7 illustrates an example of a heater grid comprising grid lines 20 and busbars 22 and 24. Busbars 22 and 24 can be designated as a positive busbar and a negative busbar, respectively. The busbars 22 and 24 have terminals 26 and 28 that are connected to a positive and negative lead of a power supply, respectively. The power supply can be the electrical system of a vehicle. Upon the application of a voltage across the heater grid, current will flow through the grid lines 20, from the positive busbar to the negative busbar and, as a result, the grid lines 20 will heat up via resistive heating.

The busbars can have a width of 5 to 25 mm and have a length of 200 to 1,000 mm. The grid lines can each independently have a width of 0.3 to 5 mm, specifically, 0.4 to 0.6 mm, or 1 to 3 mm. The grid lines can have a height of less than or equal to 0.5 mm, specifically, less than or equal to 0.1 mm, more specifically, 0.025 mm to 0.05 mm from the surface on which the grid line is printed.

The busbars 22 and 24 can be printed from the conductive mixture or can be made out of a different material. The conductive mixture for printing the busbars 22 and 24 can have lower electrical resistance than the conductive mixture used for printing the grid lines. The conductive mixture for printing the busbars 22 and 24 can exhibit a conductivity that is greater than the conductivity associated with the grid lines 20. The conductive mixture for printing the busbars, for example, can comprise a lower content of carbon particles than the conductive mixture for printing the grid lines. If made from a different material, the busbars 22 and 24 can be made, for example, of a metallic tape or a metallic insert. The conductive tape or panel can be positioned underneath or on top of the grid lines 20 in order to establish sufficient electrical connection between the busbars 22 and 24 and the grid lines 20. The metallic tape or panel can be attached to the substrate after the substrate is formed through the use of an adhesive or during the forming of the substrate as an insert (e.g., via film insert molding).

The busbars 22 and 24 can be inkjet printed. Conversely, the busbars 22 and 24 can be screen printed, for example, before or after inkjet printing of the grid lines 20. The grid lines 20 can be inkjet printed. Conversely, the grid lines 20 can be screen printed.

Blackout border 50 can be applied to the substrate by printing an opaque ink onto the surface of the substrate or through, for example, an in-mold decorating technique, including insert film molding. Blackout border 50 can comprise an encapsulation.

After printing, the printed line can be looked at to see if there are any defects. This step can be accomplished, for example, by using an infrared light. The conductive line can then be viewed by observing the reflected light. Locations where no light is reflected along the conductive line can be filled in with the conductive mixture.

After printing, the printed line can be sintered, for example, at 90 to 135°C for 0.5 to 2 hrs. After sintering the conductive line, the surface of the conductive line, such as of the busbars can be cleaned, for example, using a fiber glass brush. An example of a fiber glass brush is FYBRGLASS brush commercially available from The Eraser Company of Mattydale, NY.

The following examples are provided to illustrate articles with enhanced thermal capability. The examples are merely illustrative and are not intended to limit devices made in accordance with the disclosure to the materials, conditions, or process parameters set forth therein.

### EXAMPLES

In the examples and unless specified otherwise, the conductive mixture was prepared by adding 1 gram of 2-octanone and 0.48 gram of bis(triethoxysilyl)ethane to 30 grams of room temperature conductive paste; gently mixing the components with a spatula and then mixing in a THINKY mixer obtained from THINKY Corporation for 35 seconds at 2,000 revolutions per minute (rpm) to form a mixture; defoaming the mixture in the THINKY mixer for 20 seconds at 2,200 rpm; transferring the mixture to a dispensing barrel; and again defoaming the mixture for 20 seconds at 2,200 rpm in the THINKY mixer. The barrel was then inserted into a PICODO™ HV-100 inkjet printer commercially available from Nordson EFD™ that was attached to a robotic arm with six degrees of rotational freedom. The barrel and piston were pressurized to 520 kPa for dispensing and the conductive mixture was dispensed through a 23 gauge dispenser tip at a speed of 105 mm/s in ambient temperature of 20 to 22°C.

### Example 1: Continuous line printing of a conductive paste

A grid line was printed using a continuous stream of conductive paste using a rotary auger valve. In this type of valve system, the material cartridge is pressurized in order to provide a constant flow of material to the screw, which rotates to force material out of the nozzle. The screw speed and orifice size determine the size of the bead printed. The line is shown in images of FIG. 2 and FIG. 3. FIG. 2 shows that the printed line has surface defects including pooling 12 that can occur during start-up, bead formation 14, and line break 16. FIG. 3 shows that the printed line can have discontinuities 18 that can arise from bubbles in the conductive paste. Any one of these defects can lead to a decrease in resistivity across the length of the line. The electrical resistance of the line of FIG. 3 was measured to be only 0.07 ohms per millimeter (ohms/mm).

### Example 2: Inkjet printing of a conductive paste

A line was printed by inkjet printing. Here, a conductive paste, DOTITE FKK XA-3276 available from Fujikura Kasei Co., LTD was obtained and stored at a temperature of 4.4°C prior to use and the conductive mixture was prepared as described above. Printed lines are shown in FIG. 5 and FIG. 6.

FIG. 5 is a photograph of a printed line showing that a continuous line with no discontinuities can be printed and that sharp angles, such as the 90° angle 60 shown, can be obtained. FIG. 6 shows that the inkjet printed line can be free of surface defects. A test of nine different inkjet printed lines shows that the average resistivity of 0.011 ohms/mm with a standard deviation of only 0.0007 ohms/mm was achieved. This value is a significant improvement over the 0.07 ohms/mm as measured in the printed line of Example 1. This level of precision now opens new opportunities for backlight defroster production. It also provides entry into other similar applications, such as conductive signal pathways to replace wiring harnesses.

The inkjet printing experiment was performed on 7 different panels for 81,875 mm per panel. Over the total length printed, only 1 line break was observed.

### Example 3-5: Effect of storage conditions of the conductive paste

Three different conductive mixtures were prepared from the same components as described above, except that the storage and preparation conditions of the conductive paste were varied. In Example 3, the conductive paste was stored at room temperature for 9 weeks prior to using; in Example 4, the conductive paste was stored at 5.6°C for 9 weeks prior to using; and in Example 5, the conductive paste was vacuum processed and then stored at room temperature for 5 weeks prior to using, where the vacuum processing involved defoaming the paste by centrifugation in the container, sealing the container, and shipping.

30 serpentine lines with a length of 6,520 mm for each conductive mixture were then inkjet printed and the number of line breaks and the number of bead formations was then determined after printing a line. The results are shown in Table 1. It is noted that the dispensing pressure of the conductive mixture of Example 3 was increased slightly from 517 kPa to 565 kPa to accommodate for the increase in viscosity due to the vacuum processing.

| Table 1 | | | |
|---|---|---|---|
| Example | 1 | 2 | 3 |
| Number of line breaks | 68 | 16 | 0 |
| Number of bead formations | 32 | 15 | 1 |
| Total discontinuities | 100 | 31 | 1 |

Table 1 shows that a 69% reduction in defects can be achieved merely by maintaining the conductive paste at a cold storage temperature versus room temperature. Table 1 further shows that by vacuum processing the conductive paste, maintaining the conductive paste at the cold storage temperature, and reducing the storage time, that a 99% reduction in defects can be achieved.

Set forth below are embodiments of the present disclosure.
Embodiment 1: A printing method for forming a conductive line on a plastic substrate for use in an automobile, comprising: fixing the plastic substrate in a fixture of an automatic printing machine; dispensing a conductive mixture to an inkjet print head of the automatic printing machine, the inkjet print head being coupled to the fixture and configured for printing on the plastic substrate; and controlling the inkjet print head of the automatic printing machine with a computer controller under automatic controls and printing the conductive mixture onto the plastic substrate with the inkjet print head while the plastic substrate is fixed in the fixture to form the conductive line; wherein the conductive mixture comprises a conductive paste; a solvent; and an adhesion agent; wherein the conductive line is a busbar, a grid line, or an antenna line in the automobile.
Embodiment 2: The method of Embodiment 1, wherein an inkjet print head is optionally attached to an articulatable robot arm with 3 to 6°, specifically, 6° of freedom of movement and being moveable so as to cause relative movement of the print head along a series of scanning paths following a surface contour of the substrate.
Embodiment 3: The method of any one of the preceding embodiments, wherein the printing occurs at one or both of a frequency of 100 to 1,000 Hz, specifically, 300 to 500 Hz and a speed of 50 to 300 mm/s, specifically, 230 to 280 mm/s or 75 to 150 mm/s.
Embodiment 4: The method of any one of the preceding embodiments, wherein the inkjet print head is a barrel and piston print head comprising at least two piezoelectric actuators that raise and lower a seal to allow the conductive mixture to be released from the inkjet print head.
Embodiment 5: The method of any one of the preceding embodiments, further comprising monitoring the printing for a defect, wherein if the defect occurs, then the method further comprises retaining a defect location, for example, by storing a set of values in a memory corresponding to the defect location.
Embodiment 6: The method of Embodiment 5, wherein the defect is a line break and wherein the method further comprises automatically printing in the line break after the printing.
Embodiment 7: The method of any one of the preceding embodiments, wherein the plastic substrate comprises a 2K molded raised surface; wherein the method further comprises reducing the speed of the ink jet print head at a location where a surface height is increased or decreased due to the 2K molded raised surface.
Embodiment 8: The method of any one of the preceding embodiments, wherein the inkjet printing occurs in accordance with a preprogrammed printing path.
Embodiment 9: The method of any one of the preceding embodiments, further comprising maintaining a specified height of the print head from the surface by sensing an actual height of the print head from the substrate and if the actual height is not equal to the specified height, then the method comprises adjusting the actual height to the specified height, for example, through the use of an actuator.
Embodiment 10: The method of any one of the preceding embodiments, wherein the print head comprises two or more print heads and wherein the method further comprises controlling the dispensing of the series of droplets from each of the two or more print heads independently based upon a set of values stored in a memory of a controller.
Embodiment 11: A printing method for forming a conductive line on a plastic substrate for use in an automobile, for example, in addition to the method of any one of the preceding embodiments comprising: fixing the plastic substrate in a fixture of an automatic printing machine comprising the fixture, a screen located above the fixture, and a squeegee; dispensing a conductive mixture onto a surface of the screen; and screen printing the conductive mixture by displacing the squeegee over the surface of the screen with an applied pressure in a downward direction on the screen such that the conductive mixture floods through an open mesh space in the screen onto the surface of the plastic substrate to form the conductive line; and wherein the conductive mixture comprises a conductive paste; a solvent; and an adhesion agent; wherein the conductive line is a busbar, a grid line, or an antenna line in the automobile.
Embodiment 12: The method of Embodiment 11, wherein the screen comprises a polyester fabric (for example, comprising monofilament polyester fibers), a polyamide fabric (for example, comprising monofilament polyamide fibers), or a combination comprising at least one of the foregoing.
Embodiment 13: The method of any one of Embodiments 11-12, wherein the squeegee comprises a polyurethane, a rubber, or a combination comprising at least one of the foregoing.
Embodiment 14: The method of any one of Embodiments 11-13, wherein one or both of the displacing the squeegee occurs at a speed of 10 to 50 mm/s, specifically, 20 to 40 mm/s, more specifically, 25 to 35 mm/s and the applied pressure is 100 to 800 kPa, specifically, 300 to 600 kPa.
Embodiment 15: The method of any one of Embodiments 11-14, further comprising shaping the screen prior to the printing, for example, by using a plurality of screen shapers.
Embodiment 16: The method of any one of Embodiments 11-15, further comprising flooding the conductive mixture across the surface of the screen after the dispensing and prior to the printing.
Embodiment 17: The method of any one of Embodiments 11-16, further comprising maintaining an angle of the squeegee with respect to a tangent line of the surface of the plastic substrate during the displacing to conform to a curvature of the plastic substrate.
Embodiment 18: The method of any one of the preceding embodiments, wherein the plastic substrate has a curvature.
Embodiment 19: The method of any one of the preceding embodiments, wherein the solvent comprises a C₃₋₁₀ alkyl ketone, a C₃₋₁₀ cycloalkyl ketone, an alcohol, an ether, or a combination comprising at least one of the foregoing, specifically, wherein the solvent comprises ethanol, methanol, glycol ether, acetone, butanone, 3,3-dimethyl-2-butanone, 2-pentanone, 3-pentanone, 3,3-dimethyl-2-pentanone, 4,4-dimethyl-2-pentanone, 3,4-dimethyl-2-pentanone, 2,4-dimethyl-3-pentanone, 4-methyl-2-pentanone, 3-methyl-2-pentanone, cyclopentanone, 2-hexanone, 3-hexanone, 5-methyl-2-hexanone, 4-methyl-2-hexanone, 3-methyl-2-hexanone, 2-methyl-3-hexanone, 4-methyl-3-hexanone, 5-methyl-3-hexanone, 2-methyl-3-pentanone, cyclohexanone, 2-methylcyclohexanone, 3-methylcyclohexanone, 4-methylcyclohexanone, 2-heptanone, 3-heptanone, 4-heptanone, cycloheptanone, 2-octanone, 3-octanone, 4-octanone, cycloctanone, a C₉ ketone, a C₁₀ ketone, or a combination comprising at least one of the foregoing.
Embodiment 20: The method of any one of the preceding embodiments, wherein the conductive paste comprises silver, copper, or a combination comprising at least one of the foregoing.
Embodiment 21: The method of any one of the preceding embodiments, wherein the solvent is present in an amount of 0.1 to 5 grams, specifically, 0.5 to 2 grams of solvent per 30 grams of the conductive mixture.
Embodiment 22: The method of any one of the preceding embodiments, wherein the adhesion agent comprises gamma-isocyanatopropyltriethoxysilane, n-ethyl-3-trimethoxysilyl-2-methyl propanamine, gamma-isocyanatopropyltrimethoxysilane, 3-amino propyltriethoxysilane, n-beta-(aminoethyl)-gamma-aminopropyltrimethoxysilane, triethoxysilylpropylenecarbamate, glycidoxypropyltrimethoxysilane, methyltrimethoxysilane, neopentyl(diallyl) oxytri(dodecyl)benzene-sulfonyl titanate, vinylbenzylethylene diamine propyl trimethoxysilane monohydrochloride, vinyltrimethoxysilane, octadecylaminodimethyl trimethoxysilyl propyl ammonium chloride, cyanodecyltrimethoxysilane, mercapto propyl trimethoxysilane, chloropropyltrimethoxysilane, bis(triethoxysilyl)ethane, or a combination comprising at least one of the foregoing.
Embodiment 23: The method of any one of the preceding embodiments, wherein the adhesion agent is present in an amount of 0.1 to 2 grams, specifically, 0.1 to 1 grams per 30 grams of the conductive mixture.
Embodiment 24: The method of any one of the preceding embodiments, wherein a viscosity of the conductive mixture is less than or equal to 36,000 mPa-s.
Embodiment 25: The method of any one of the preceding embodiments, wherein the conductive mixture is a degassed mixture.
Embodiment 26: The method of any one of the preceding embodiments, further comprising degassing the mixture prior to the printing.
Embodiment 27: The method of any one of the preceding embodiments, wherein the substrate comprises polycarbonate.
Embodiment 28: The method of any one of the preceding embodiments, wherein the substrate comprises one or both of a UV absorbent layer and an abrasion resistant layer on one or both sides of the plastic substrate.
Embodiment 29: The method of any one of the preceding embodiments, further comprising depositing one or both of a UV absorbent layer and an abrasion resistant layer on one or both sides of the plastic substrate after the printing.
Embodiment 30: The method of any one of the preceding embodiments, further comprising, prior to the printing: maintaining the conductive paste at a cold storage temperature of 0 to 10°C, specifically, 2 to 6°C; mixing and warming the conductive paste from the cold storage temperature to an increased temperature of 11 to 30°C; degassing the conductive paste at the increased temperature, the solvent, and the adhesion agent to form the mixture.
Embodiment 31: The method of Embodiment 30, further comprising transferring the mixture to the dispensing container, for example, a syringe; mixing and degassing the mixture in the dispensing container within 2 hours of the transferring.
Embodiment 32: The method of any one of Embodiments 30-31, wherein the maintaining the conductive paste at the cold storage temperature occurs for less than or equal to 6 months.
Embodiment 33: The method of any one of the preceding embodiments, wherein the printing prints a grid line having a thickness of 0.3 to 5 mm, specifically, 0.4 to 0.6 mm, or 1 to 3 mm.
Embodiment 34: The method of any one of the preceding embodiments, wherein an average width of a first two millimeters of the line is within 10% of an average width of a two millimeter long location downstream of the first two millimeters.
Embodiment 35: The method of any one of the preceding embodiments, further comprising centrifugally rotating the mixture at a centrifugal force of greater than or equal to 350 G, specifically, greater than or equal to 400 G prior to the printing.
Embodiment 36: The method of any one of the preceding embodiments, wherein the method is capable of printing a 90° angle in the line.
Embodiment 37: The method of any one of the preceding embodiments, further comprising sintering the conductive mixture after printing, for example, at 90 to 135°C for 0.5 to 2 hrs.
Embodiment 38: The method of any one of the preceding embodiments, further comprising printing the gridline and the busbar to form a heater grid, and inspecting a quality of the heater grid using an infrared camera.
Embodiment 39: A method of forming a heater grid comprising a plurality of grid lines, a first busbar, and a second busbar; the method comprising: inkjet printing the plurality of grid lines by the method of any one of Embodiments 1-10 and 18-37; and screen printing the first busbar and the second busbar by the method of any one of Embodiments 11-37; wherein a current can flow from the first busbar through the plurality of grid lines to the second busbar.
Embodiment 40: Use of a mixture comprising a conductive paste; a solvent; and an adhesion agent in inkjet printing or screen printing.

All ranges disclosed herein are inclusive of the endpoints, and the endpoints are independently combinable with each other (e.g., ranges of "up to 25 wt%, or, more specifically, 5 to 20 wt%", is inclusive of the endpoints and all intermediate values of the ranges of "5 to 25 wt%," etc.). "Combination" is inclusive of blends, mixtures, alloys, reaction products, and the like. Furthermore, the terms "first," "second," and the like, herein do not denote any order, quantity, or importance, but rather are used to denote one element from another. The terms "a" and "an" and "the" herein do not denote a limitation of quantity, and are to be construed to cover both the singular and the plural, unless otherwise indicated herein or clearly contradicted by context. "Or" means "and/or." The suffix "(s)" as used herein is intended to include both the singular and the plural of the term that it modifies, thereby including one or more of that term (e.g., the film(s) includes one or more films). Reference throughout the specification to "one embodiment," "another embodiment," "an embodiment," and so forth, means that a particular element (e.g., feature, structure, and/or characteristic) described in connection with the embodiment is included in at least one embodiment described herein, and may or may not be present in other embodiments. "Optional" or "optionally" means that the subsequently described event or circumstance can or cannot occur, and that the description includes instances where the event occurs and instances where it does not. Unless defined otherwise, technical and scientific terms used herein have the same meaning as is commonly understood by one of skill in the art to which this disclosure belongs. Unless otherwise stated, test standards are the most recent as of the filing date of the priority application.

## Claims

1. A printing method for forming a conductive line on a plastic substrate (104) for use in an automobile, comprising:
fixing the plastic substrate (104) in a fixture of an automatic printing machine;
dispensing a conductive mixture to an inkjet print head (100) of the automatic printing machine, the inkjet print head (100) being coupled to the fixture and configured for printing on the plastic substrate (104); and
controlling the inkjet print head (100) of the automatic printing machine with a computer controller under automatic controls and printing the conductive mixture onto the plastic substrate (104) with the inkjet print head (100) while the plastic substrate (104) is fixed in the fixture to form the conductive line; wherein the conductive line is a busbar (22, 24), a grid line (20), or an antenna line in the automobile;
wherein the conductive mixture comprises a conductive paste; a solvent; and an adhesion agent.

2. The method of Claim 1, wherein the inkjet print head (100) is a barrel and piston print head comprising at least two piezoelectric actuators that raise and lower a seal to allow the conductive mixture to be released from the inkjet print head (100).

3. The method of any one of the preceding claims, wherein the plastic substrate (104) comprises a 2K molded raised surface (84); wherein the method further comprises reducing a speed of the inkjet print head (100) at a location where a surface height is increased or decreased due to the 2K molded raised surface (84).

4. A printing method for forming a conductive line on a plastic substrate (104) for use in an automobile, comprising:
screen printing a screen printed line; wherein the screen printing comprises
fixing the plastic substrate in a fixture (214) of an automatic printing machine (210) comprising the fixture (214), a screen located above the fixture (214), and a squeegee;
dispensing the conductive mixture onto a surface of the screen; wherein the conductive mixture comprises a conductive paste; a solvent; and an adhesion agent; and
printing the conductive mixture by displacing the squeegee over the surface of the screen with an applied pressure in a downward direction on the screen such that the conductive mixture floods through an open mesh space in the screen onto the surface of the plastic substrate to form the screen printed conductive line; wherein the screen printed conductive line is a busbar (22, 24), a grid line (20), or an antenna line in the automobile.

5. The method of any one of the preceding claims, wherein the plastic substrate has a curvature.

6. The method of any one of the preceding claims, wherein the solvent comprises a C₃₋₁₀ alkyl ketone, a C₃₋₁₀ cycloalkyl ketone, an alcohol, an ether, or a combination comprising at least one of the foregoing; and/or
wherein the solvent is present in an amount of 0.1 to 5, specifically, 0.5 to 2 g of solvent per 30 g of the conductive mixture.

7. The method of any one of the preceding claims, wherein the conductive paste comprises silver, copper, or a combination comprising at least one of the foregoing.

8. The method of any one of the preceding claims, wherein the adhesion agent comprises gamma-isocyanatopropyltriethoxysilane, n-ethyl-3-trimethoxysilyl-2-methyl propanamine, gamma-isocyanatopropyltrimethoxysilane, 3-aminopropyltriethoxysilane, n-beta-(aminoethyl)-gamma-aminopropyltrimethoxysilane, triethoxysilylpropylenecarbamate, glycidoxypropyltrimethoxysilane, methyltrimethoxysilane, neopentyl(diallyl) oxytri(dodecyl) benzene-sulfonyl titanate, vinyltrimethoxysilane, vinylbenzylethylene diaminepropyl trimethoxysilane monohydrochloride, octadecylaminodimethyl trimethoxysilyl propyl ammonium chloride, cyanodecyltrimethoxysilane, mercaptopropyltrimethoxysilane, chloropropyltrimethoxysilane, bis(triethoxysilyl)ethane, or a combination comprising at least one of the foregoing; and/or
wherein the adhesion agent is present in an amount of 0.1 to 2, specifically, 0.1 to 1 g per 30 g of the conductive mixture.

9. The method of any one of the preceding claims, wherein a viscosity of the conductive mixture is less than or equal to 36,000 mPa-s.

10. The method of any one of the preceding claims, further comprising degassing the mixture prior to the printing by centrifugally rotating the mixture at a centrifugal force of greater than or equal to 350, specifically, greater than or equal to 400 G prior to the printing.

11. The method of any one of the preceding claims, further comprising, prior to the printing:
maintaining the conductive paste at a cold storage temperature of 0 to 10°C, specifically, 2 to 6°C;
mixing and warming the conductive paste from the cold storage temperature to an increased temperature of 11 to 30°C; and
degassing the conductive paste at the increased temperature, the solvent, and the adhesion agent to form the mixture.

12. The method of Claim 11, further comprising transferring the mixture to a dispensing container; mixing and degassing the mixture in the dispensing container within 2 hours of the transferring; and/or
wherein the maintaining the conductive paste at the cold storage temperature occurs for less than or equal to 6 months.

13. The method of any one of the preceding claims, wherein the printing prints a grid line (20) having a thickness of 0.3 to 5 mm, specifically, 0.4 to 0.6 mm, or 1 to 3 mm and wherein an average width of a first two millimeters of the line is within 10% of an average width of a two millimeter long location downstream of the first two millimeters.

14. The method of any one of the preceding claims, further comprising sintering the conductive mixture after printing at 90 to 135°C for 0.5 to 2 hrs.

15. A method of forming a heater grid comprising a plurality of grid lines, a first busbar (22), and a second busbar (24); the method comprising:
inkjet printing the plurality of grid lines (20) by the method of any one of Claims 1-3 and 5-14; and
screen printing the first busbar (22) and the second busbar (24) by the method of any one of Claims 4-14;
wherein a current can flow from the first busbar (22) through the plurality of grid lines (20) to the second busbar (24).

## Patentansprüche

1. Druckverfahren zum Bilden einer leitfähigen Zeile auf einem Kunststoffsubstrat (104) zur Verwendung in einem Automobil, umfassend:
Befestigen des Kunststoffsubstrats (104) in einer Halterung einer automatischen Druckmaschine;
Abgeben einer leitfähigen Mischung an einen Tintenstrahldruckkopf (100) der automatischen Druckmaschine, wobei der Tintenstrahldruckkopf (100) mit der Halterung gekoppelt und für das Drucken auf dem Kunststoffsubstrat (104) konfiguriert ist; und
Steuern des Tintenstrahldruckkopfs (100) der automatischen Druckmaschine mit einer Computersteuerung unter automatischen Steuerungen und Drucken der leitfähigen Mischung auf das Kunststoffsubstrat (104) mit dem Tintenstrahldruckkopf (100) während das Kunststoffsubstrat (104) in der Halterung befestigt ist, um die leitfähige Zeile zu bilden; wobei die leitfähige Zeile eine Sammelschiene (22, 24), eine Netzleitung (20) oder eine Antennenleitung in dem Automobil ist;
wobei die leitfähige Mischung eine leitfähige Paste; ein Lösungsmittel; und einen Klebstoff umfasst.

2. Verfahren nach Anspruch 1, wobei der Tintenstrahldruckkopf (100) ein Trommel- und Kolbendruckkopf ist, welcher zumindest zwei piezoelektrische Stellantriebe umfasst, welche eine Dichtung heben und senken, um der leitfähigen Mischung zu erlauben, von dem Tintenstrahldruckkopf (100) freigegeben zu werden.

3. Verfahren nach einem der vorstehenden Ansprüche, wobei das Kunststoffsubstrat (104) eine erhöhte 2K-Spritzgussoberfläche (84) umfasst; wobei das Verfahren weiter Verringern einer Geschwindigkeit des Tintenstrahldruckkopfs (100) an einem Ort umfasst, an dem eine Oberflächenhöhe aufgrund der erhöhten 2K-Spritzgussoberfläche (84) erhöht oder verringert ist.

4. Druckverfahren zum Bilden einer leitfähigen Zeile auf einem Kunststoffsubstrat (104) zur Verwendung in einem Automobil, umfassend:
Siebdrucken einer siebgedruckten Zeile; wobei das Siebdrucken umfasst
Befestigen des Kunststoffsubstrats in einer Halterung (214) einer automatischen Druckmaschine (210), umfassend die Halterung (214), ein Sieb, welches sich über der Halterung (214) befindet, und eine Rakel;
Abgeben der leitfähigen Mischung auf eine Oberfläche des Siebs; wobei die leitfähige Mischung eine leitfähige Paste; ein Lösungsmittel; und einen Klebstoff umfasst; und
Drucken der leitfähigen Mischung durch Versetzen der Rakel über der Oberfläche des Siebs mit einem angewendeten Druck in einer Abwärtsrichtung des Siebs, sodass die leitfähige Mischung durch einen offenen Raum des Netzes in dem Sieb auf die Oberfläche des Kunststoffsubstrats fließt, um die siebgedruckte leitfähige Zeile zu bilden; wobei die siebgedruckte leitfähige Zeile eine Sammelschiene (22, 24), eine Netzleitung (20) oder eine Antennenleitung in dem Automobil ist.

5. Verfahren nach einem der vorstehenden Ansprüche, wobei das Kunststoffsubstrat eine Wölbung aufweist.

6. Verfahren nach einem der vorstehenden Ansprüche, wobei das Lösungsmittel ein C₃₋₁₀ Alkylketon, ein C₃₋₁₀ Cycloalkylketon, einen Alkohol, einen Ether oder eine Kombination, umfassend zumindest eines der vorstehenden umfasst; und/oder
wobei das Lösungsmittel in einer Menge von 0,1 bis 5, spezifisch 0,5 bis 2 g Lösungsmittel pro 30 g der leitfähigen Mischung vorhanden ist.

7. Verfahren nach einem der vorstehenden Ansprüche, wobei die leitfähige Paste Silber, Kupfer oder eine Kombination, umfassend zumindest eines der vorstehenden umfasst.

8. Verfahren nach einem der vorstehenden Ansprüche, wobei der Klebstoff Gamma-Isocyanatopropyltriethoxysilan, n-Ethyl-3-trimethoxysilyl-2-methyl-propanamin, Gamma-Isocyanatopropyltrimethoxysilan, 3-Aminopropyltriethoxysilan, n-beta-(Aminoethyl)-gamma-aminopropyltrimethoxysilan, Triethoxysilylpropylenecarbamat, Glycidoxypropyltrimethoxysilan, Methyltrimethoxysilan, Neopentyl(diallyl) Oxytri(dodecyl) Benzolsulfonyltitanat, Vinyltrimethoxysilan, Vinylbenzylethylen Diaminepropan Trimethoxysilan Monohydrochlorid, Octadecylaminodimethyl Trimethoxysilyl Propyl-Ammoniumchlorid, Cyanodecyltrimethoxysilan, Mercaptopropyltrimethoxysilan, Chloropropyltrimethoxysilan, bis(triethoxysilyl)ethan, oder eine Kombination, umfassend zumindest eines der vorstehenden umfasst; und/oder
wobei der Klebstoff in einer Menge von 0,1 bis 2, spezifisch 0,1 bis 1 g pro 30 g der leitfähigen Mischung vorhanden ist.

9. Verfahren nach einem der vorstehenden Ansprüche, wobei eine Viskosität der leitfähigen Mischung kleiner oder gleich 36.000 mPa-s ist.

10. Verfahren nach einem der vorstehenden Ansprüche, weiter Entgasen der Mischung vor dem Drucken durch zentrifugales Rotieren der Mischung bei einer Zentrifugalkraft von größer oder gleich 350, spezifisch größer oder gleich 400 G vor dem Drucken umfassend.

11. Verfahren nach einem der vorstehenden Ansprüche, weiter umfassend, vor dem Drucken:
Bewahren der leitfähigen Paste bei einer Kühlraumtemperatur von 0 bis 10 °C, spezifisch 2 bis 6 °C;
Mischen und Erwärmen der leitfähigen Paste von der Kühlraumtemperatur auf eine erhöhte Temperatur von 11 bis 30 °C; und
Entgasen der leitfähigen Paste bei der erhöhten Temperatur, des Lösungsmittels und des Klebstoffs, um die Mischung zu bilden.

12. Verfahren nach Anspruch 11, weiter Transferieren der Mischung in einen Abgabebehälter; Mischen und Entgasen der Mischung in dem Abgabebehälter innerhalb von 2 Stunden nach dem Transfer umfassend; und/oder
wobei das Bewahren der leitfähigen Paste bei der Kühlraumtemperatur für kleiner oder gleich 6 Monate auftritt.

13. Verfahren nach einem der vorstehenden Ansprüche, wobei das Drucken eine Netzleitung (20) mit einer Dicke von 0,3 bis 5 mm, spezifisch 0,4 bis 0,6 mm, oder 1 bis 3 mm druckt und wobei eine durchschnittliche Breite von ersten zwei Millimetern der Zeile innerhalb von 10 % einer durchschnittlichen Breite eines zwei Millimeter langen Orts nach den ersten zwei Millimetern liegt.

14. Verfahren nach einem der vorstehenden Ansprüche, weiter Sintern der leitfähigen Mischung nach dem Drucken bei 90 bis 135 °C für 0,5 bis 2 Std. umfassend.

15. Verfahren zum Bilden eines Heiznetzes, umfassend eine Vielzahl von Netzleitungen, eine erste Sammelschiene (22) und eine zweite Sammelschiene (24); wobei das Verfahren umfasst:
Tintenstrahldrucken der Vielzahl von Netzleitungen (20) durch das Verfahren nach einem der Ansprüche 1-3 und 5-14; und
Siebdrucken der ersten Sammelschiene (22) und der zweiten Sammelschiene (24) durch das Verfahren nach einem der Ansprüche 4-14;
wobei ein Strom von der ersten Sammelschiene (22) durch die Vielzahl von Netzleitungen (20) zu der zweiten Sammelschiene (24) fließen kann.

## Revendications

1. Procédé d'impression pour former une ligne conductrice sur un substrat en plastique (104) pour une utilisation dans une automobile, comprenant le fait :
de fixer le substrat en plastique (104) dans un élément de fixation d'une machine d'impression automatique ;
de distribuer un mélange conducteur à une tête d'impression à jet d'encre (100) de la machine d'impression automatique, la tête d'impression à jet d'encre (100) étant couplée à l'élément de fixation et configurée pour une impression sur le substrat en plastique (104) ; et
de commander la tête d'impression à jet d'encre (100) de la machine d'impression automatique avec un dispositif de commande informatique sous des commandes automatiques et d'imprimer le mélange conducteur sur le substrat en plastique (104) avec la tête d'impression à jet d'encre (100) tandis que le substrat en plastique (104) est fixé dans l'élément de fixation pour former la ligne conductrice ; où la ligne conductrice est une barre omnibus (22, 24), une ligne de quadrillage (20) ou une ligne d'antenne dans l'automobile ;
dans lequel le mélange conducteur comprend une pâte conductrice ; un solvant ; et un agent d'adhérence.

2. Procédé de la revendication 1, dans lequel la tête d'impression à jet d'encre (100) est une tête d'impression à cylindre et à piston comprenant au moins deux actionneurs piézoélectriques qui lèvent et abaissent un joint d'étanchéité pour permettre au mélange conducteur d'être libéré de la tête d'impression à jet d'encre (100).

3. Procédé de l'une quelconque des revendications précédentes, dans lequel le substrat en plastique (104) comprend une surface surélevée moulée par injection 2K (84) ; dans lequel le procédé comprend en outre la réduction d'une vitesse de la tête d'impression à jet d'encre (100) à un emplacement où une hauteur de surface est augmentée ou diminuée en raison de la surface surélevée moulée par injection 2K (84).

4. Procédé d'impression pour former une ligne conductrice sur un substrat en plastique (104) pour une utilisation dans une automobile, comprenant :
la sérigraphie d'une ligne sérigraphiée ; où la sérigraphie comprend le fait
de fixer le substrat en plastique dans un élément de fixation (214) d'une machine d'impression automatique (210) comprenant l'élément de fixation (214), un écran situé au-dessus de l'élément de fixation (214), et une raclette ;
de distribuer le mélange conducteur sur une surface de l'écran ; où le mélange conducteur comprend une pâte conductrice ; un solvant ; et un agent d'adhérence ; et
d'imprimer le mélange conducteur par déplacement de la raclette sur la surface de l'écran avec une pression appliquée dans une direction vers le bas sur l'écran de sorte que le mélange conducteur pénètre à travers un espace de maille ouverte dans l'écran sur la surface du substrat en plastique pour former la ligne conductrice sérigraphiée ; où la ligne conductrice sérigraphiée est une barre omnibus (22, 24), une ligne de quadrillage (20) ou une ligne d'antenne dans l'automobile.

5. Procédé de l'une quelconque des revendications précédentes, dans lequel le substrat en plastique a une courbure.

6. Procédé de l'une quelconque des revendications précédentes, dans lequel le solvant comprend une alkylcétone en C₃ à C₁₀, une cycloalkylcétone en C₃ à C₁₀, un alcool, un éther ou une combinaison comprenant au moins l'un des éléments précédents ; et/ou
dans lequel le solvant est présent en une quantité allant de 0,1 à 5, en particulier, de 0,5 à 2 g de solvant pour 30 g du mélange conducteur.

7. Procédé de l'une quelconque des revendications précédentes, dans lequel la pâte conductrice comprend de l'argent, du cuivre, ou une combinaison comprenant au moins l'un des éléments précédents.

8. Procédé de l'une quelconque des revendications précédentes, dans lequel l'agent d'adhérence comprend le gamma-isocyanatopropyltriéthoxysilane, la n-éthyl-3-triméthoxysilyl-2-méthylpropanamine, le gamma-isocyanatopropyltriméthoxysilane, le 3-aminopropyltriéthoxysilane, le n-bêta-(aminoéthyl)-gamma-aminopropyltriméthoxysilane, le triéthoxysilylpropylènecarbamate, le glycidoxypropyltriméthoxysilane, le méthyltriméthoxysilane, le titanate de néopentyl(diallyl)oxytri(dodécyl)benzène-sulfonyle, le vinyltriméthoxysilane, le monochlorhydrate de vinylbenzyléthylène diaminepropyl triméthoxysilane, le chlorure d'octadécylaminodiméthyl triméthoxysilyl propyl ammonium, le cyanodécyltriméthoxysilane, le mercaptopropyltriméthoxysilane, le chloropropyltriméthoxysilane, le bis(triéthoxysilyl)éthane, ou une combinaison comprenant au moins l'un des éléments précédents ; et/ou
dans lequel l'agent d'adhérence est présent en une quantité allant de 0,1 à 2, en particulier, de 0,1 à 1 g pour 30 g du mélange conducteur.

9. Procédé de l'une quelconque des revendications précédentes, dans lequel une viscosité du mélange conducteur est inférieure ou égale à 36000 mPa-s.

10. Procédé de l'une quelconque des revendications précédentes, comprenant en outre le dégazage du mélange avant l'impression par rotation centrifuge du mélange à une force centrifuge supérieure ou égale à 350, en particulier, supérieure ou égale à 400 G avant l'impression.

11. Procédé de l'une quelconque des revendications précédentes, comprenant en outre, avant l'impression, le fait :
de maintenir la pâte conductrice à une température de stockage à froid allant de 0 à 10°C, en particulier, de 2 à 6°C ;
de mélanger et chauffer la pâte conductrice de la température de stockage à froid à une température augmentée de 11 à 30°C ; et
de dégazer la pâte conductrice à la température augmentée, le solvant et l'agent d'adhérence pour former le mélange.

12. Procédé de la revendication 11, comprenant en outre le fait de transférer le mélange dans un récipient de distribution ; de mélanger et de dégazer le mélange dans le récipient de distribution dans les 2 heures suivant le transfert ; et/ou
où le maintien de la pâte conductrice à la température de stockage à froid a lieu pendant une durée inférieure ou égale à 6 mois.

13. Procédé de l'une quelconque des revendications précédentes, dans lequel l'impression imprime une ligne de quadrillage (20) ayant une épaisseur allant de 0,3 à 5 mm, en particulier, de 0,4 à 0,6 mm, ou de 1 à 3 mm et dans lequel une largeur moyenne de deux premiers millimètres de la ligne est dans la plage de 10% d'une largeur moyenne d'un emplacement de deux millimètres de long en aval des deux premiers millimètres.

14. Procédé de l'une quelconque des revendications précédentes, comprenant en outre le frittage du mélange conducteur après l'impression à une température de 90 à 135°C pendant 0,5 à 2 heures.

15. Procédé de formation d'un quadrillage chauffant comprenant une pluralité de lignes de quadrillage, une première barre omnibus (22) et une deuxième barre omnibus (24) ; le procédé comprenant le fait :
d'imprimer par jet d'encre la pluralité de lignes de quadrillage (20) par le procédé de l'une quelconque des revendications 1 à 3 et 5 à 14 ; et
de sérigraphier la première barre omnibus (22) et la deuxième barre omnibus (24) par le procédé de l'une quelconque des revendications 4 à 14 ;
dans lequel un courant peut circuler de la première barre omnibus (22) à travers la pluralité de lignes de quadrillage (20) jusqu'à la deuxième barre omnibus (24).
